# EUROPÄISCHE PATENTSCHRIFT

(11) **EP 4 315 388 B1**
(45) Veröffentlichungstag und Bekanntmachung des Hinweises auf die Patenterteilung: **23.04.2025**
(21) Anmeldenummer: 22716930.7
(22) Anmeldetag: 21.03.2022
(51) Int. Cl.: H01J 37/32, G01N 21/67, H05H 1/00, H05H 1/24, G01N 21/3504

(54) **VORRICHTUNG UND VERFAHREN ZUR PLASMAERZEUGUNG IN EINEM GROSSEN DRUCKBEREICH SOWIE SYSTEM UND VERFAHREN ZUR OPTISCHEN GASANALYSE/-DETEKTION MITTELS EINER SOLCHEN VORRICHTUNG**
DEVICE AND METHOD FOR PLASMA GENERATION IN A WIDE PRESSURE RANGE AND SYSTEM AND METHOD FOR OPTICAL GAS ANALYSIS/DETECTION BY MEANS OF SUCH A DEVICE
DISPOSITIF ET PROCÉDÉ DE GÉNÉRATION DE PLASMA DANS UNE LARGE PLAGE DE PRESSION ET SYSTÈME ET PROCÉDÉ D'ANALYSE/DÉTECTION DE GAZ OPTIQUE AU MOYEN D'UN TEL DISPOSITIF

(30) Priorität: 31.03.2021 CH 3422021
(43) Veröffentlichungstag der Anmeldung: 07.02.2024
(73) Patentinhaber: Inficon AG, 9496 Balzers (LI)
(72) Erfinder: WALDNER, Astrid, 7310 Bad Ragaz (CH); ANDREAUS, Bernhard, 8640 Rapperswil (CH); WÄLCHLI, Urs, 7000 Chur (CH); KAISER, Stefan, 9491 Ruggell (LI)
(74) Vertreter: Troesch Scheidegger Werner AG
(86) Internationale Anmeldenummer: PCT/EP2022/057384
(87) Internationale Veröffentlichungsnummer: WO 2022/207396

(56) Entgegenhaltungen:
- EP-A1- 3 702 760
- WO-A1-2021/052600
- US-A1- 2010 224 322

## Beschreibung

### TECHNISCHES GEBIET DER ERFINDUNG

Die vorliegende Erfindung betrifft eine Vorrichtung und ein Verfahren zur Plasmaerzeugung. Weiter betrifft die Erfindung ein System zur optischen Gasanalyse und/oder Gasdetektion, beispielsweise ein Messgerät zum Bestimmen einer Gaszusammensetzung oder zum Nachweisen eines bestimmten Gases, mittels einer solchen Vorrichtung sowie ein Verfahren zum Betrieb des Systems.

Die vorliegende Erfindung gehört zum technischen Gebiet der Plasmaerzeugung, dem Ionisieren und Anregen von Molekülen und Ionen, um Plasmalicht zu erzeugen, und weiter der Messung und Auswertung von Informationen über die Gaszusammensetzung des erzeugten Plasmas.

### HINTERGRUND DER ERFINDUNG

Zur quantitativen und qualitativen Analyse von gasförmigen Proben wird häufig die optische Emissionsspektrometrie (OES) eingesetzt. Die Methode beruht darauf, dass angeregte Atome eine für das chemische Element charakteristische elektromagnetische Strahlung aussenden und somit Informationen über die Zusammensetzung der Probe liefern. Die Anregung der Atome erfolgt beispielsweise durch eine Überführung der Probe in den Plasmazustand. Bekannte Instrumente zur Durchführung der optischen Emissionsspektrometrie benutzen jeweils eine bestimmte Plasmaquelle, bei der die Plasmaerzeugung in einem definierten Druckbereich langlebig und stabil funktioniert. Viele Anwendungen betreffen jedoch einen sehr grossen Druckbereich, in dem die Gaszusammensetzung eine wesentliche Rolle spielt und daher gemessen und kontrolliert bzw. überwacht werden soll. Es werden daher eine Vielzahl von Plasma-erzeugenden Instrumenten benötigt, was zu einem hohen Aufwand an Elektronik, Software, Platz, Energie und Kosten führt. Somit werden mehrere Messgeräte wie Spektrometer und auch mehrere Flansch-Ports an dem System benötigt, wo das Gas über einen grossen Druckbereich analysiert werden soll. Bekannte Systeme zur optischen Emissionspektrometrie sind in US 2010/224322 A1, EP 3 702 760 A1, und WO 2021/052600 A1 genannt.

Es besteht daher ein Bedarf Instrumente zu entwickeln, welche eine stabile Erzeugung eines Plasmas und dessen Emissionslicht in einem bzw. über einen grossen Druckbereich, z.B. von 10⁻⁸ Torr (Hochvakuum) bis 1500 Torr (> Normaldruck), bei minimalen räumlichen Anforderungen und möglichst geringem Aufwand an Elektronik, Software, Energie und Kosten ermöglichen.

### ZUSAMMENFASSUNG DER ERFINDUNG

Eine Aufgabe der vorliegenden Erfindung besteht darin, eine Vorrichtung zur Plasmaerzeugung in einem (bzw. über einen) grossen Druckbereich bereitzustellen, welche möglichst platzsparend an eine Anlage (oder ein System), aus welcher ein Gas analysiert und/oder nachgewiesen werden soll, angeschlossen werden kann, und weniger aufwändig und kostensparender ist im Vergleich zu bekannten Vorrichtungen zur Plasmaerzeugung. Diese Aufgabe wird erfindungsgemäss durch die Vorrichtung nach Anspruch 1 gelöst.

Weiter ist es eine Aufgabe der vorliegenden Erfindung ein System zur optischen Gasanalyse bzw. Gasdetektion anzugeben, welche eine solch vorteilhafte Vorrichtung zur Plasmaerzeugung umfasst. Diese Aufgabe wird durch das System gemäss Anspruch 16 gelöst.

Es ist zudem eine Aufgabe der vorliegenden Erfindung ein entsprechendes Verfahren zur Plasmaerzeugung in einem (bzw. über einen) grossen Druckbereich vorzuschlagen. Ein solches Verfahren wird in Anspruch 17 spezifiziert.

Ferner ist es eine Ausgabe der vorliegenden Erfindung ein entsprechendes Verfahren zur optischen Gasanalyse bzw. Gasdetektion vorzuschlagen. Ein solches Verfahren wird in Anspruch 20 angegeben.

Spezifische erfindungsgemässe Ausführungsvarianten werden in den abhängigen Ansprüchen angegeben.

Eine erfindungsgemässe Vorrichtung zur Plasmaerzeugung in einem grossen Druckbereich umfasst:
- eine erste Plasmaquelle, wobei die erste Plasmaquelle in einer ersten Entladungskammer angeordnet ist und dazu ausgeführt ist, ein erstes Plasma in einem Niederdruckbereich zu erzeugen, wobei sich der Niederdruckbereich insbesondere bis Hochvakuum, d.h. beispielsweise bis 10⁻⁸ Torr, erstreckt;
- eine zweite Plasmaquelle, wobei die zweite Plasmaquelle in einer zweiten Entladungskammer angeordnet ist und dazu ausgeführt ist, ein zweites Plasma in einem Hochdruckbereich zu erzeugen, wobei sich der Hochdruckbereich insbesondere bis über Normaldruck, d.h. beispielsweise bis 1500 Torr, erstreckt;
- ein erstes Ankopplungselement, insbesondere mit einem Flansch, zur Ankopplung der Vorrichtung an ein System (insbesondere eine Gasquelle), wobei das Ankopplungselement dazu ausgeführt ist, Gas aus dem System herauszuführen;
- ein zweites Ankopplungselement zur Ankopplung der Vorrichtung an einen optischen Sensor, wie z.B. eine Fotodiode oder ein Spektrometer, zur optischen Gasanalyse bzw. Gasdetektion (bzw. Gasdruckmessung),
wobei die erste Entladungskammer eine erste optische Verbindung mit mindestens einer optischen Linse zum zweiten Ankopplungselement aufweist und die zweite Entladungskammer eine zweite optische Verbindung mit mindestens einer optischen Linse zum zweiten Ankopplungselement aufweist (wobei die optische Linse eine gemeinsame optische Linse der ersten und zweiten optischen Verbindung sein kann).

Die erfindungsgemässe Vorrichtung zeichnet sich folglich dadurch aus, dass sie mindesten zwei unterschiedliche Entladungsformen erzeugen kann, d.h. zwei oder mehr Plasmaquellen aufweist, welche in dieser (einzigen) Vorrichtung (zusammen) integriert sind. Weiter weist die Vorrichtung lediglich einen (Anschluss-)Flansch auf, mit welchem Sie an das System mit dem zu analysierenden Gas angeschlossen werden kann, und sie weist auch nur eine Ankopplung an einen (einzigen) optischen Sensor, wie z.B. ein Spektrometer auf, um die optische Gasanalyse im gesamten Druckbereich, z.B. von 10⁻⁸ Torr bis 1500 Torr durchzuführen. Die (beiden) Entladungskammern der (beiden) Plasmaquellen können dabei parallel zueinander oder in Reihe (Serie, nacheinander) angeordnet sein, und das zu analysierende bzw. zu detektierende Gas kann parallel den einzelnen Entladungskammern zugeführt werden oder von einer Entladungskammer in die nächste hindurchgeführt werden. Es ist auch eine Kombination von parallel/nebeneinander und in Reihe/Serie angeordneten Entladungskammern mit Plasmaquellen denkbar, die miteinander fluidisch verbunden oder aber gasdicht entkoppelt sind.

Das vom jeweiligen Plasma emittierte Licht wird über eine optische Verbindung von der jeweiligen Entladungskammer zum zweiten Ankopplungselement (vor dem optischen Sensor) geführt. Dabei weist jede optische Verbindung eine optische Linse auf, wobei z.B. zwei optische Verbindungen auch eine gemeinsame optische Linse aufweisen können. Die optischen Verbindungen können nebst einer oder mehreren optischen Linsen z.B. auch geeignete Lichtleiter(-Elemente) wie Fasern, Röhren oder Stäbe umfassen.

In einer Ausführungsvariante der Vorrichtung erstreckt sich der Niederdruckbereich und der Hochdruckbereich zusammen über einen Druckbereich von mindesten 10 Dekaden, insbesondere über 12 Dekaden (z.B. in Torr).

In einer weiteren Ausführungsvariante der Vorrichtung überlappen sich der Niederdruckbereich und der Hochdruckbereich, insbesondere über einen Druckbereich von einer Dekade, z.B. von 0.35 Torr bis 3.5 Torr.

In einer weiteren Ausführungsvariante der Vorrichtung sind die erste und zweite Plasmaquelle unterschiedliche Plasmaquellen, z.B. je eine aus der Gruppe bestehend aus einer Glimmentladungsquelle (glow discharge; Kaltkathoden-Quelle), einer stillen Entladungsquelle (dielektrische Barriere-Entladung bzw. dielektrisch behinderte Entladung, DBE; dielectric barrier discharge, DBD), einer Hochfrequenz-Plasmaquelle (RF plasma source), einer Mikrowellen-Plasmaquelle (-> Normal-/Atmosphärendruckplasma) und einer induktiv gekoppelten Plasmaquelle (inductively coupled plasma, ICP source).

In einer weiteren Ausführungsvariante der Vorrichtung ist die erste Entladungskammer mit der zweiten Entladungskammer fluidisch gekoppelt (insbesondere herrscht in beiden Entladungskammern der gleiche oder nahezu derselbe Druck).

In einer weiteren Ausführungsvariante der Vorrichtung ist die erste Entladungskammer von der zweiten Entladungskammer gasdicht entkoppelt.

In einer weiteren Ausführungsvariante der Vorrichtung ist Gas vom ersten Ankopplungselement in die erste Entladungskammer zuführbar und von der ersten in die zweite Entladungskammer zuführbar.

In einer weiteren Ausführungsvariante der Vorrichtung ist Gas vom ersten Ankopplungselement getrennt in die erste Entladungskammer und in die zweite Entladungskammer zuführbar.

In einer weiteren Ausführungsvariante der Vorrichtung ist zwischen der ersten Entladungskammer und der zweiten Entladungskammer eine optische Linse angeordnet, welche Teil der ersten optischen Verbindung ist.

In einer weiteren Ausführungsvariante der Vorrichtung umfasst das zweite Ankopplungselement eine optische Linse, welche Teil der ersten und/oder der zweiten optischen Verbindung ist.

In einer weiteren Ausführungsvariante der Vorrichtung ist die zweite optische Verbindung Teil der ersten optischen Verbindung, d.h. die beiden optischen Verbindungen überlappen sich teilweise bzw. streckenweise.

In einer weiteren Ausführungsvariante umfasst die Vorrichtung ferner ein Drucksensor. Der Drucksensor kann beispielsweise einer der folgenden sein:
- Wärmeleitungsvakuummeter nach Pirani (für einen Messbereich ca. von 10⁻³ Torr bis 1 Torr);
- Ionisations-Vakuummeter mit Kaltkathode nach Penning (für einen Messbereich von ca. 10⁻⁷ Torr bis 10⁻³ Torr);
- Ionisations-Vakuummeter mit Glühkathode nach Bayard-Alpert (für einen Messbereich von ca. 10⁻¹² Torr bis 10⁻³ Torr);
- kapazitives Membranvakuummeter (capacitance diaphragm (vacuum) gauge, CDG; für einen Messbereich von ca. 10⁻⁵ Torr bis 10³ Torr).

Um einen grossen Druckbereich, z.B. von 10⁻⁸ Torr bis 1500 Torr, abzudecken, kann die Vorrichtung auch mehrere Drucksensoren aufweisen.

In einer weiteren Ausführungsvariante umfasst die Vorrichtung ferner eine Steuerung, welche dazu ausgeführt ist, in Abhängigkeit des mit Hilfe des Drucksensors (bzw. der Drucksensoren) bestimmten Drucks (bzw. Drücke) die erste und/oder die zweite Plasmaquelle zu steuern, insbesondere die erste und/oder die zweite Plasmaquelle ein- oder auszuschalten.

In einer weiteren Ausführungsvariante der Vorrichtung sind die erste Entladungskammer und die zweite Entladungskammer zylinderförmig ausgeführt und hintereinander (in Reihe) koaxial (auf einer gemeinsamen Zylinderachse) angeordnet, wobei das erste Ankopplungselement an der ersten Entladungskammer angeordnet ist und das zweite Ankopplungselement an der zweiten Entladungskammer angeordnet ist, wobei die erste Plasmaquelle insbesondere eine Glimmentladungsquelle (Kaltkathoden-Quelle) ist und wobei die zweite Plasmaquelle insbesondere eine stille Entladungsquelle (für dielektrische Barriere-Entladung) ist.

In einer weiteren Ausführungsvariante der Vorrichtung ist eine Anode der ersten Plasmaquelle vakuumdicht in einer Durchführung durch die optische Linse im zweiten Ankopplungselement eingeglast, und insbesondere auch (z.B. vakuumdicht) in einer Durchführung durch die optische Linse, welche zwischen der ersten Entladungskammer und der zweiten Entladungskammer angeordnet ist, eingeglast, und die beiden Durchführungen sind insbesondere zentrisch in den beiden optischen Linsen angeordnet, und die Anode erstreckt sich koaxial (auf der gemeinsamen Zylinderachse der beiden Entladungskammern) durch die zweite Entladungskammer hindurch bis in die erste Entladungskammer.

In einer weiteren Ausführungsvariante der Vorrichtung weist die zweite Plasmaquelle eine Hochspannungselektrode und eine Masse-Elektrode auf, wobei die Hochspannungselektrode in ein Dielektrikum eingebettet ist, welches zumindest Teil einer Innenwand der zweiten Entladungskammer bildet, und die Masse-Elektrode ist konzentrisch zur Hochspannungselektrode innerhalb der zweiten Entladungskammer und entlang der Innenwand, in einem Abstand von weniger als 1 mm, insbesondere zwischen 0.05 mm und 0.5 mm, zur Hochspannungselektrode angeordnet, insbesondere auf einem Hohlzylinder, z.B. aus Keramik, wobei sich zwischen der Innenwand und der Masse-Elektrode ein Spalt befindet, in dem sich beim Anlegen einer Wechselspannung zwischen der Hochspannungselektrode und der Masse-Elektrode, z.B. mit einer Spannung im Bereich von ±1 bis ±10 kV und einer Frequenz im Bereich von 1 bis 10 kHz, eine Entladungszone mit einem Plasma (nämlich dem zweiten Plasma) bildet. Beispielsweise kann der Spannungsverlauf über eine Periode der Wechselspannung von -5 kV zu +5 kV und wieder zurück wechseln, d.h. eine Spannung von 10 kVₚₚ (von Spitze zu Spitze, peak-to-peak) angelegt werden. Der Spannungsverlauf kann beispielsweise einem Sinus-Verlauf entsprechen. Eine Rechteck-Spannung ist ebenfalls möglich. Vorteilhaft ist es, die Spannung von positiv zu negativ gegenüber Massepotential zu variieren. Auf diese Weise erhält man ein deutlich stabileres Plasma als beispielsweise durch eine Variation zwischen Null (GND) und positiver Spannung oder zwischen Null (GND) und negativer Spannung. Hochspannungselektrode und Masse-Elektrode können beispielsweise beide als dünnwandige Hohlzylinder ausgebildet sein. Diese beiden Elektroden können beispielsweise auch segmentiert sein, d.h. aus leitenden Streifen aufgebaut sein, welche nebeneinander auf einer zylindrischen Oberfläche liegen.

In einer weiteren Ausführungsvariante der Vorrichtung ist die Hochspannungselektrode für einen Betrieb der ersten Plasmaquelle mit Masse (z.B. schaltbar/gesteuert) verbindbar und für einen Betrieb der zweiten Plasmaquelle mit einer Hochspannungswechselstromquelle (z.B. schaltbar/gesteuert) verbindbar, und/oder ist die Anode für einen Betrieb der ersten Plasmaquelle mit einer Hochspannungsgleichstromquelle (z.B. 3.3 kV DC-Spannung) verbindbar (z.B. schaltbar bzw. gesteuert) und für einen Betrieb der zweiten Plasmaquelle mit Masse (z.B. schaltbar/gesteuert) verbindbar.

In einer weiteren Ausführungsvariante der Vorrichtung führen eine koaxiale Anordnung der Anode (insbesondere) innerhalb der ersten Entladungskammer, wobei die Entladungskammer als Kathode dient, und eine radiale Anordnung der Hochspannungselektrode sowie der Masse-Elektrode (an der Innenwand der zweiten Entladungskammer) dazu, dass sich ein von der ersten Plasmaquelle erzeugtes erstes Plasma an der Zylinderachse der ersten Entladungskammer bildet und vom ersten Plasma emittiertes erste Licht sich insbesondere axial zum zweiten Ankopplungselement hin ausbreitet, und dass sich ein von der zweiten Plasmaquelle erzeugtes zweites Plasma an der Innenwand der zweiten Entladungskammer bildet und vom zweiten Plasma emittiertes zweite Licht sich insbesondere schräg zur Zylinderachse der zweiten Entladungskammer zum zweiten Ankopplungselement hin ausbreitet, sodass das erste Licht und das zweite Licht aus unterschiedlichen Richtungen auf die optische Linse im zweiten Ankopplungselement treffen.

In einer weiteren Ausführungsvariante der Vorrichtung ist die Anode aus Molybdän.

In einer weiteren Ausführungsvariante der Vorrichtung ist die erste Entladungskammer aus Titan.

In einer weiteren Ausführungsvariante der Vorrichtung ist die Hochspannungselektrode aus Platin.

In einer weiteren Ausführungsvariante der Vorrichtung ist das Dielektrikum aus Saphir (Al₂O₃).

In einer weiteren Ausführungsvariante der Vorrichtung ist die Masse-Elektrode aus Molybdän.

In einer weiteren Ausführungsvariante der Vorrichtung ist die optische Linse bzw. sind die optischen Linsen aus Saphir (Al₂O₃).

Gemäss einem weiteren Aspekt der vorliegenden Erfindung umfasst ein System zur optischen Gasanalyse bzw. Gasdetektion (bzw. Gasdruckmessung):
- eine Vorrichtung zur Plasmaerzeugung gemäss einer der oben angegebenen Ausführungsvarianten;
- eine Gasquelle, wobei die Vorrichtung zur Plasmaerzeugung mit einem ersten Ankopplungselement, insbesondere mit einem Flansch, an die Gasquelle gekoppelt ist;
- ein optischer Sensor, wie z.B. eine Fotodiode oder ein Spektrometer zur optischen Gasanalyse bzw. Gasdetektion (bzw. Gasdruckmessung), wobei die Vorrichtung zur Plasmaerzeugung mit einem zweiten Ankopplungselement an den optischen Sensor gekoppelt ist.

Gemäss einem weiteren Aspekt der vorliegenden Erfindung umfasst ein Verfahren zur Plasmaerzeugung in einem grossen Druckbereich mittels der Vorrichtung zur Plasmaerzeugung gemäss einer der oben angegebenen Ausführungsvarianten folgende Schritte:
- Zuführen eines Gases aus einem System via ein erstes Ankopplungselement in eine erste Entladungskammer mit einer ersten Plasmaquelle und/oder in eine zweite Entladungskammer mit einer zweiten Plasmaquelle;
- Erzeugen eines ersten Plasmas durch die erste Plasmaquelle in einem Niederdruckbereich in der ersten Entladungskammer, wobei sich der Niederdruckbereich insbesondere bis Hochvakuum, d.h. beispielsweise bis 10⁻⁸ Torr, erstreckt, und/oder Erzeugen eines zweiten Plasmas durch die zweite Plasmaquelle in einem Hochdruckbereich in der zweiten Entladungskammer, wobei sich der Hochdruckbereich insbesondere bis über Normaldruck, d.h. beispielsweise bis 1500 Torr, erstreckt;
- Leiten von Licht, welches vom ersten Plasma emittiert wird, von der ersten Entladungskammer via eine erste optische Verbindung mit mindestens einer optischen Linse und/oder von Licht, welches vom zweiten Plasma emittiert wird, von der zweiten Entladungskammer via eine zweite optische Verbindung mit mindestens einer optischen Linse zu einem zweiten Ankopplungselement zur Ankopplung der Vorrichtung an einen optischen Sensor, wie z.B. eine Fotodiode oder ein Spektrometer;
- Auskoppeln zumindest eines Teils des Lichtes, welches vom ersten und/oder vom zweiten Plasma emittiert wird, durch das zweite Ankopplungselement.

In einer Ausführungsvariante des Verfahrens ist die zweite Plasmaquelle eine stille Entladungsquelle mit einer Hochspannungselektrode und einer Masse-Elektrode, wobei zum Erzeugen des zweiten Plasmas eine Wechselspannung zwischen der Hochspannungselektrode und der Masse-Elektrode angelegt wird, z.B. mit einer Spannung im Bereich von ±1 bis ±10 kV und einer Frequenz im Bereich von 1 bis 10 kHz.

In einer weiteren Ausführungsvariante des Verfahrens wird in Abhängigkeit des mit Hilfe eines Drucksensors bestimmten Drucks die erste und/oder die zweite Plasmaquelle angesteuert, insbesondere wird die erste und/oder die zweite Plasmaquelle ein- oder ausgeschaltet.

In einer weiteren Ausführungsvariante des Verfahrens erzeugen in einem Druckbereich, in dem sich der Niederdruckbereich und der Hochdruckbereich überlappen, z.B. in einem Druckbereich von 0.35 Torr bis 3.5 Torr, die erste und zweite Plasmaquelle gleichzeitig ein erstes und ein zweites Plasma.

Gemäss einem weiteren Aspekt der vorliegenden Erfindung umfasst ein Verfahren zur optischen Gasanalyse bzw. Gasdetektion (bzw. Gasdruckmessung) das Ausführen der Schritte gemäss einem der oben angegebenen Ausführungsvarianten des Verfahrens zur Plasmaerzeugung sowie weiter folgende Schritte:
- Leiten des ausgekoppelten Lichtes an einen optischen Sensor, wie z.B. eine Fotodiode oder ein Spektrometer;
- Bestimmen eines Gases oder von Bestandteilen eines Gases oder Nachweisen eines bestimmten Gases oder bestimmter Bestandteile eines Gases (oder Bestimmen eines Drucks eines Gases) aufgrund des ausgekoppelten Lichtes, insbesondere einer Intensität und/oder einer spektralen Verteilung des ausgekoppelten Lichtes.

Wenn nun in einem Druckbereich, in dem sich der Niederdruckbereich und der Hochdruckbereich überlappen, also z.B. in einem Druckbereich von 0.35 Torr bis 3.5 Torr, die erste und zweite Plasmaquelle gleichzeitig ein erstes und ein zweites Plasma erzeugen, so führt dies zu einer erhöhten Empfindlichkeit der optischen Gasanalyse bzw. Gasdetektion aufgrund der höheren (z.B. doppelten) Intensität des Lichtes beider Plasmen. Dies kann beispielsweise für die Spurengas-Detektion hilfreich sein. Eine solche gleichzeitige Plasmaerzeugung durch die erste und zweite Plasmaquelle kann auch bei der Identifikation oder der Bestimmung des partiellen Anteils eines Spurengases (Partialdruck/-konzentration) hilfreich sein, da die Fraktionierung des Gases durch die beiden Plasmen unterschiedlich ist. Des Weiteren ist es möglich mit Hilfe des Analyseergebnisses des Lichtes vom ersten (bzw. zweiten) Plasma das Analyseergebnis des Lichtes vom zweiten (bzw. ersten) Plasma zu korrigieren bzw. das eine zwecks einer Kalibration des anderen zu verwenden.

Es sei angemerkt, dass Kombinationen der oben genannten Ausführungsvarianten möglich sind, die wiederum zu spezifischeren Ausführungsvarianten der vorliegenden Erfindung führen.

### KURZE BESCHREIBUNG DER ZEICHNUNGEN

Nichtlimitierende Ausführungsbeispiele der vorliegenden Erfindung werden nachstehend anhand von Figuren noch näher erläutert. Es zeigen:
- Fig. 1: eine schematische Darstellung eines Ausführungsbeispiels einer erfindungsgemässen Vorrichtung zur Plasmaerzeugung in einem grossen Druckbereich;
- Fig. 2: ein Längsschnitt durch ein Ausführungsbeispiel einer erfindungsgemässen Vorrichtung zur Plasmaerzeugung in einem grossen Druckbereich mit Grössenangaben;
- Fig. 3: eine alternative Darstellung des Längsschnitts durch das Ausführungsbeispiel gemäss Fig. 2 mit eingezeichneten Plasmenbereichen
- Fig. 4: eine Variante der Vorrichtung; und
- Fig. 5: eine weitere Variante der Vorrichtung.

In den Figuren stehen gleiche Bezugszeichen für gleiche Elemente.

### DETAILLIERTE BESCHREIBUNG DER ERFINDUNG

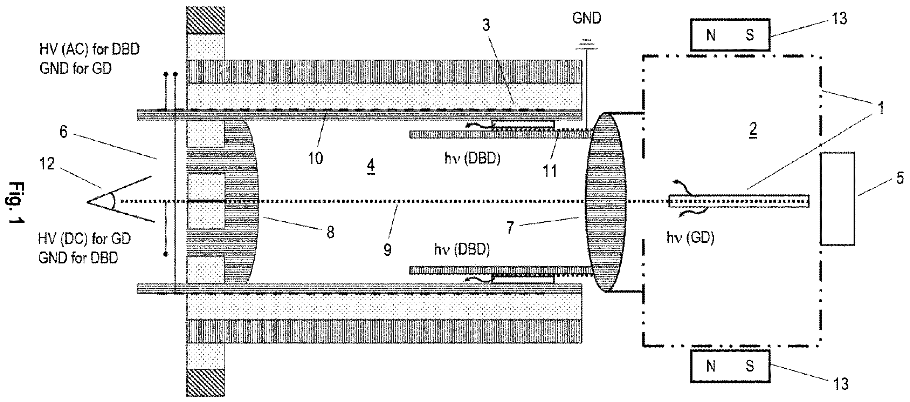

Fig. 1 zeigt in einer schematischen Darstellung ein Ausführungsbeispiel einer erfindungsgemässen Vorrichtung zur Plasmaerzeugung in einem grossen Druckbereich. Die Vorrichtung umfasst eine erste Plasmaquelle 1, z.B. eine Glimmentladungsquelle (GD, Kaltkathoden-Quelle), welche in einer ersten Entladungskammer 2 angeordnet ist, und eine zweite Plasmaquelle 3, z.B. eine stille Entladungsquelle (DBD-Quelle), welche in einer zweiten Entladungskammer 4 angeordnet ist, wobei die beiden Entladungskammern 2, 4 hintereinander (in Reihe), aneinander angrenzend angeordnet sind. Weiter umfasst die Vorrichtung ein erstes Ankopplungselement 5, z.B. mit einem Flansch, zur Ankopplung der Vorrichtung an ein System (nicht eingezeichnet), in dem sich ein Gas befindet. Das Gas wird via das Ankopplungselement 5 aus dem System heraus in die erste Entladungskammer 2 hineingeführt. Von der ersten Entladungskammer 2 kann das Gas in die zweite Entladungskammer 4 hineinfliessen. Dazu befinden sich beispielsweise mehrere (z.B. 6 bis 12) Belüftungslöcher mit je einem Durchmesser von mindestens 1 mm zwischen den beiden Entladungskammern 2, 4. Weiter umfasst die Vorrichtung ein zweites Ankopplungselement 6 zur Ankopplung der Vorrichtung an einen optischen Sensor, wie z.B. eine Fotodiode oder ein Spektrometer, zur optischen Gasanalyse bzw. Gasdetektion (oder auch zur Gasdruckmessung).

Die erste Plasmaquelle 1 ist zur Erzeugung eines Plasmas in einem Niederdruckbereich, z.B. von 10⁻⁸ Torr bis ca. 3.5 Torr, geeignet, und die zweite Plasmaquelle 2 ist zur Erzeugung eines Plasmas in einem Hochdruckbereich, z.B. von ca. 0.35 Torr bis 1500 Torr, geeignet. Je nach Druck des Gases wird daher die erste (bei niedrigem Druck -> Hochvakuum) oder die zweite (bei atmosphärischem Druck) Plasmaquelle 1, 3 das Gas entzünden und dadurch ein erstes oder zweites Plasma 14, 15 erzeugen, welches in Abhängigkeit der Art bzw. Zusammensetzung des Gases unterschiedliches Licht emittiert. In dem Drucküberlappungsbereich der beiden Plasmaquellen 1, 3, z.B. von 0.35 Torr bis 3.5 Torr, können auch beide Plasmaquellen 1, 3 zeitgleich aktiv sein und damit gleichzeitig ein erstes sowie ein zweites Plasma 14, 15 erzeugen. Dieser Parallelbetrieb beider Plasmaquellen 1, 3 ist insbesondere möglich wegen der geringen Leistung beider Entladungen.

Das vom ersten Plasma 14 in der ersten Entladungskammer 2 emittierte Licht wird durch eine optische Linse 7 geführt, welche sich zwischen den beiden Entladungskammern 2, 4 befindet. Danach wird das Licht durch die zweite Entladungskammer 4 geführt und gelangt durch eine zweite optische Linse 8, welche sich im zweiten Ankopplungselement 6 befindet, an einen optischen Sensor 12, mit dessen Hilfe eine optische Gasanalyse oder Gasdetektion (oder auch eine Gasdruckmessung) ausgeführt werden kann. Der optische Sensor 12 ist in dem Wellenlängenbereich empfindlich, welcher durch die beiden optischen Linsen 7, 8 transmittiert werden kann. Der optische Sensor 12 kann ein einfacher Strahlungssensor, z.B. ein Lichtsensor wie eine Fotodiode sein, es kann sich aber auch um einen komplexeren optischen Sensor handeln, z.B. ein Spektrometer.

Die Anode 9 der ersten Plasmaquelle 1 wird vom zweiten Ankopplungselement 6 durch die zweite optische Linse 8 im zweiten Ankopplungselement 6 durch die zweite Entladungskammer 4 durch die erste optische Linse 7 zwischen den beiden Entladungskammern 2, 4 hindurch in die erste Entladungskammer 2 geführt. Die Anode 9 ist insbesondere vakuumdicht in einer Durchführung durch die optische Linse 8 im zweiten Ankopplungselement 6 eingeglast. Die Anode 9 kann ebenfalls in einer Durchführung durch die optische Linse 7 zwischen den beiden Entladungskammern 2, 4 eingeglast sein. Die Durchführung durch die optische Linse 7 kann ebenfalls vakuumdicht ausgeführt sein, wobei dies nicht zwingend erforderlich ist. Die beiden Durchführungen sind insbesondere zentrisch in den beiden optischen Linsen 7, 8 angeordnet, sodass sich die Anode 9 koaxial durch die zweite Entladungskammer 4 hindurch bis in die erste Entladungskammer 2 erstreckt.

Die Kathode der ersten Plasmaquelle 1 befindet sich am Rand der ersten Entladungskammer 2 von der Anode 9 beabstandet. Die Innenwand der ersten Entladungskammer 2 kann dabei die Kathode bilden. Die Kathode besteht beispielsweise aus Titan. Um eine Glimmentladung des Gases zu erzeugen, wird zwischen der Anode 9 und der Kathode eine hohe Gleichspannung (HV DC) beispielsweise von 3.3 kV angelegt. Diese hohe Spannung beschleunigt Elektronen aus dem Kathoden-Material in Richtung Anode 9. Durch Anlegen eines äusseren Magnetfeldes mittels (Permanent-)Magnete 13 werden die Elektronen auf Kreis- bzw. Spiralbahnen gelenkt. Dies erhöht die Wahrscheinlichkeit des Aufpralls mit einem Atom/Molekül des Gases. Diese Kollisionen führen zur Anregung bzw. Ionisierung des Atoms/Moleküls. Die Ionen wandern Richtung Kathode und generieren so einen Ionenstrom. Photonen werden einerseits durch Relaxation der angeregten Atome, Moleküle, Ionen und andererseits durch Rekombination dieser Ionen generiert. Die emittierten Photonen strahlen in den ganzen Raum und treffen unter anderem auf die erste optische Linse 7 zwischen den beiden Entladungskammern 2, 4. Hier werden die eintreffenden Photonen gebrochen und zur zweiten optischen Linse 8 im zweiten Ankopplungselement 6 geleitet. Die optischen Linsen 7, 8 können aus einem oder mehreren Materialien bestehen, z.B. aus Saphir, sowie eine asphärische Form haben, um der sphärischen bzw. chromatischen Aberration entgegenzuwirken.

Der optische Wellenlängenbereich umfasst elektromagnetische Strahlung mit Wellenlängen von 100 nm bis 1 mm, d.h. insbesondere die Bereiche des sichtbaren Lichts, der Ultraviolett-Strahlung und der Infrarot-Strahlung.

Details betreffend die zweite Plasmaquelle 3, d.h. der Vorrichtung zur Erzeugung einer stillen Plasmaentladung, können der gleichentags wie die vorliegende Patentanmeldung einreichten Schweizer Patentanmeldung mit dem Titel "Vakuumdurchführung, Elektrodenanordnung und Vorrichtung zur Erzeugung einer stillen Plasmaentladung" von derselben Anmelderin wie die vorliegende Patentanmeldung entnommen werden. Die zweite Plasmaquelle 3 weist eine Hochspannungselektrode 10 und eine Masse-Elektrode 11 auf, wobei die Hochspannungselektrode 10 in ein Dielektrikum eingebettet ist, welches zumindest Teil einer Innenwand der zweiten Entladungskammer 4 bildet. Die Masse-Elektrode 11 ist konzentrisch zur Hochspannungselektrode 10 an der Innenwand der zweiten Entladungskammer 4, insbesondere auf einem Hohlzylinder, z.B. aus Keramik, angeordnet. Die Masse-Elektrode 11 befindet sich in einem Abstand von weniger als 1 mm zur Hochspannungselektrode 10, wobei sich zwischen der Innenwand und der Masse-Elektrode 11 ein Spalt befindet, in dem sich beim Anlegen einer hohen Wechselspannung (HV AC) zwischen der Hochspannungselektrode 10 und der Masse-Elektrode 11 eine Entladungszone mit dem (zweiten) Plasma 15 bildet. Die Erfinder haben erkannt, dass sich mit dieser Ausdehnung des Spalts eine dielektrische Barriere-Entladung (alternativ auch als dielektrisch behinderte Entladung, DBE bekannt; engl. dielectric barrier discharge, DBD) mit einer hohen Wechselspannung im Bereich ±1 bis ±10 kV und einer Frequenz im Bereich von 1 bis 10 kHz über einen grossen Druckbereich ca. von 0.35 Torr bis 1500 Torr stabil erzeugen lässt.

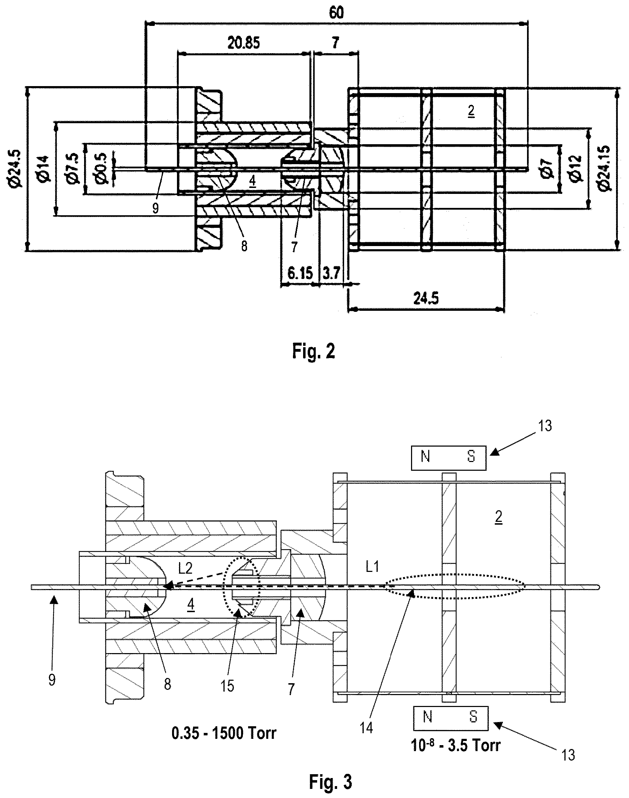

In Fig. 2 ist ein Längsschnitt durch ein Ausführungsbeispiel einer erfindungsgemässen Vorrichtung zur Plasmaerzeugung in einem grossen Druckbereich gezeigt zusammen mit Grössenangaben. In dieser Ausführungsvariante sind die erste Entladungskammer 2 und die zweite Entladungskammer 4 zylinderförmig ausgeführt und hintereinander koaxial angeordnet (sozusagen "in Reihe/ Serie geschaltet"). Wie in Fig. 1 ist das erste Ankopplungselement 5 rechts an der ersten Entladungskammer 2 angeordnet und das zweite Ankopplungselement 6 links an der zweiten Entladungskammer 4 angeordnet. Die Gesamtlänge der Vorrichtung beträgt in diesem Beispiel nur gerade ca. 60 mm und der Gesamtdurchmesser beträgt in diesem Bespiel nur etwa 25 mm. Wie dies zeigt, ermöglicht die vorliegende Erfindung eine sehr kompakte Bauweise, die folglich sehr platzsparend ist.

Fig. 3 zeigt eine alternative Darstellung des Längsschnitts durch das Ausführungsbeispiel gemäss Fig. 2. In Fig. 3 sind zudem die Plasmen 14, 15 in den beiden Entladungskammern 2, 4 dargestellt sowie schematisch die beiden optischen Verbindungen L1, L2 angedeutet. Die Bereiche in denen die Plasmen 14, 15 entstehen sind mit gestrichelten Linien umrandet.

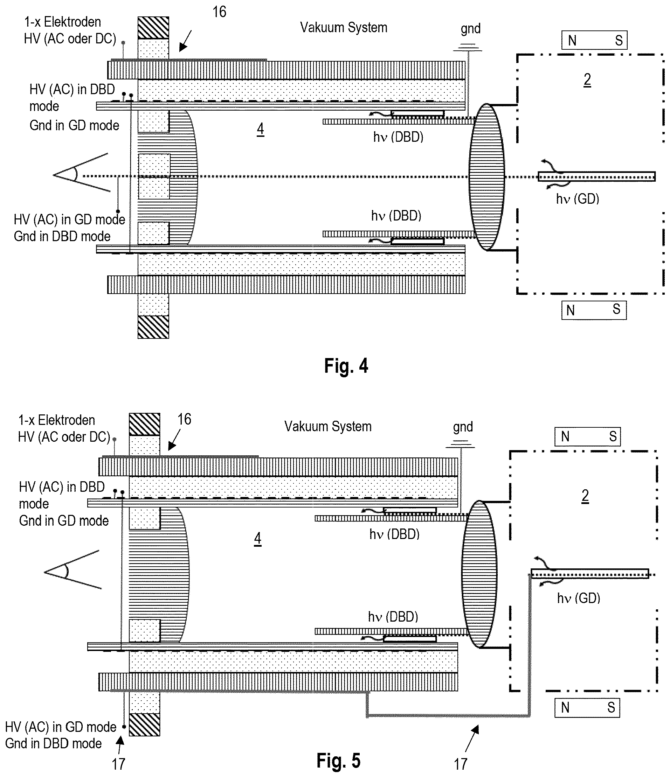

Fig. 4 zeigt einen Längsschnitt durch eine Ausführungsform, welche weitgehend mit der in Fig. 1 gezeigten Ausführungsform übereinstimmt. Zusätzlich weist diese Variante mindestens eine weitere Elektrode 16 auf, welche radial ausserhalb der Hochspannungselektrode 10 der zweiten Plasmaquelle und von dieser isoliert von der Vakuum-Seite auf die Aussenseite geführt ist. Diese weitere Elektrode ist beispielsweise zwischen einem Schmelzglasgring und einem Zylinder aus isolierendem Material hindurchgeführt. Dabei kann der Zylinder aus isolierendem Material beispielsweise auf beidseitig über den Schmelzglasring hinausragen, um so für die Elektrode eine durchgehende Auflagefläche zu bilden. Eine Mehrzahl solcher weiterer Elektroden ist möglich, wobei die Elektroden beispielsweise streifenförmig ausgebildet sein können mit einer Längsrichtung parallel zur Längsachse der Vorrichtung. Mehrere solche weitere Elektroden können in azimutaler Richtung verteilt und gegeneinander isoliert angeordnet sein, sodass die meisten in dieser Längsschnitt-Darstellung nicht sichtbar wären resp. nicht sichtbar sind. Eine oder mehrere solche Elektroden ermöglichen den Anschluss weiterer Sensoren auf der Vakuumseite oder auch alternative Arten des Anschlusses der bisher besprochenen Anoden und Kathoden der ersten und zweiten Plasmaquelle.

Fig. 5 zeigt eine gegenüber der Ausführungsform aus Fig. 4 weiter mit einem alternativen Anschluss 17 zur Anode der ersten Plasmaquelle. Die Durchführung von der Aussenseite auf die Plasmaseite ist so ausgeführt, wie in Zusammenhang mit Fig. 4 für die weitere Elektrode 16 besprochen und liegt der im Längsschnitt sichtbaren weiteren Elektrode 16 im dargestellten Fall in Bezug auf die Längsachse der Vorrichtung 180 Grad gegenüber. Durch eine Bohrung wird der alternative Anschluss 17 in die erste Entladungskammer 2 hineingeführt kontaktiert den zentralen Anodenstift. Damit kann die in der Variante gemäss Fig. 4 zentral durch die zweite Entladungskammer 4 geführte elektrische Verbindung und die damit verbundenen Durchführung durch die erste 7 und zweite 8 optische Linse wegfallen. Dies hat den Effekt, dass ein grösserer Anteil der elektromagnetischen Strahlung aus dem ersten resp. aus dem zweiten Plasma nach aussen gelangt. Elektroden können beispielsweisen über ihre komplette Länge mit einer Isolierschicht abgedeckt sein.

Dies hat den Vorteil, dass in der Elektronen-/Ionenoptik oftmals unerwünschte offenliegende Potentiale, welche geladene Teilchen beeinflussten könnten, vermieden werden. Dazu kann beispielsweise ein über den Elektroden liegender Glasring weiter axial ausgedehnt werden oder einzelnen Leiterbahnen können mit einer dünnen Glasschicht, welche überlappend über der jeweiligen Leiterbahn liegt verwirklicht sein.

Vorteile der vorliegenden Erfindung bestehen darin, dass mehrere Plasmaquellen in einer einzigen Vorrichtung zusammen integriert werden, wobei die Vorrichtung zudem nur einen einzigen Anschluss zur Einleitung des zu analysierenden Gases aufweist sowie nur einen einzigen Anschluss zur Ankopplung der Vorrichtung an einen optischen Sensor aufweist. Mit der erfindungsgemässen Vorrichtung kann ein stabiles Plasma über einen Druckbereich von über ca. 12 Dekaden (in Torr) erzeugt werden, vom Hochvakuum (10⁻⁸ Torr) bis über Normaldruck (> atmosphärischem Druck, z.B. 1500 Torr). Erfindungsgemäss ist zudem vorgesehen, durch eine Vorrichtungsinterne Druckmessung die jeweilige optimale Plasmaquelle abhängig vom Druckbereich auszuwählen und zu steuern.

### LISTE DER BEZUGSZEICHEN

- 1: erste Plasmaquelle
- 2: erste Entladungskammer
- 3: zweite Plasmaquelle
- 4: zweite Entladungskammer
- 5: erstes Ankopplungselement
- 6: zweites Ankopplungselement
- 7: erste optische Linse (zwischen den beiden Entladungskammern)
- 8: zweite optische Linse (im zweiten Ankopplungselement)
- 9: Anode der ersten Plasmaquelle
- 10: Hochspannungselektrode der zweiten Plasmaquelle
- 11: Masse-Elektrode der zweiten Plasmaquelle
- 12: optischer Sensor (z.B. Fotodiode oder Spektrometer)
- 13: (Permanent-)Magnet
- 14: erstes Plasma
- 15: zweites Plasma
- 16: weitere Elektrode
- 17: alternativer Anschluss zur Anode der ersten Plasmaquelle
- L1: erste optische Verbindung
- L2: zweite optische Verbindung

## Patentansprüche

1. Vorrichtung zur Plasmaerzeugung in einem grossen Druckbereich umfassend:
- eine erste Plasmaquelle (1), wobei die erste Plasmaquelle (1) in einer ersten Entladungskammer (2) angeordnet ist und dazu ausgeführt ist, ein erstes Plasma (14) in einem Niederdruckbereich zu erzeugen, wobei sich der Niederdruckbereich insbesondere bis Hochvakuum, d.h. beispielsweise bis 10⁻⁸ Torr, erstreckt;
- eine zweite Plasmaquelle (3), wobei die zweite Plasmaquelle (3) in einer zweiten Entladungskammer (4) angeordnet ist und dazu ausgeführt ist, ein zweites Plasma (15) in einem Hochdruckbereich zu erzeugen, wobei sich der Hochdruckbereich insbesondere bis über Normaldruck, d.h. beispielsweise bis 1500 Torr, erstreckt;
- ein erstes Ankopplungselement (5), insbesondere mit einem Flansch, zur Ankopplung der Vorrichtung an ein System, wobei das Ankopplungselement (5) dazu ausgeführt ist, Gas aus dem System herauszuführen;
- ein zweites Ankopplungselement (6) zur Ankopplung der Vorrichtung an einen optischen Sensor, wie z.B. eine Fotodiode oder ein Spektrometer, zur optischen Gasanalyse bzw. Gasdetektion,
wobei die erste Entladungskammer (2) eine erste optische Verbindung (L1) mit mindestens einer optischen Linse (7, 8) zum zweiten Ankopplungselement (6) aufweist und die zweite Entladungskammer (4) eine zweite optische Verbindung (L2) mit mindestens einer optischen Linse (8) zum zweiten Ankopplungselement (6) aufweist.

2. Vorrichtung nach Anspruch 1, wobei sich der Niederdruckbereich und der Hochdruckbereich zusammen über einen Druckbereich von mindesten 10 Dekaden, insbesondere über 12 Dekaden, erstrecken.

3. Vorrichtung nach Anspruch 1 oder 2, wobei sich der Niederdruckbereich und der Hochdruckbereich überlappen, insbesondere über einen Druckbereich von einer Dekade, z.B. von 0.35 Torr bis 3.5 Torr.

4. Vorrichtung nach einem der Ansprüche 1 bis 3, wobei die erste und zweite Plasmaquelle (1, 3) unterschiedliche Plasmaquellen sind, z.B. je eine aus der Gruppe bestehend aus einer Glimmentladungsquelle, einer stillen Entladungsquelle, einer Hochfrequenz-Plasmaquelle, einer Mikrowellen-Plasmaquelle und einer induktiv gekoppelten Plasmaquelle.

5. Vorrichtung nach einem der Ansprüche 1 bis 4, wobei die erste Entladungskammer (2) mit der zweiten Entladungskammer (4) fluidisch gekoppelt ist.

6. Vorrichtung nach einem der Ansprüche 1 bis 5, wobei Gas vom ersten Ankopplungselement (5) in die erste Entladungskammer (2) zuführbar ist und von der ersten Entladungskammer (2) in die zweite Entladungskammer (4) zuführbar ist.

7. Vorrichtung nach einem der Ansprüche 1 bis 6, wobei zwischen der ersten Entladungskammer (2) und der zweiten Entladungskammer (4) eine optische Linse (7) angeordnet ist, welche Teil der ersten optischen Verbindung (L1) ist.

8. Vorrichtung nach einem der Ansprüche 1 bis 7, wobei das zweite Ankopplungselement (6) eine optische Linse (8) umfasst, welche Teil der ersten und/oder der zweiten optischen Verbindung (L1, L2) ist.

9. Vorrichtung nach einem der Ansprüche 1 bis 8, wobei die zweite optische Verbindung (L2) Teil der ersten optischen Verbindung (L1) ist.

10. Vorrichtung nach einem der Ansprüche 1 bis 9, wobei die Vorrichtung ferner ein Drucksensor umfasst.

11. Vorrichtung nach Anspruch 10, wobei die Vorrichtung ferner eine Steuerung umfasst, welche dazu ausgeführt ist, in Abhängigkeit des mit Hilfe des Drucksensors bestimmten Drucks die erste und/oder die zweite Plasmaquelle (1, 3) zu steuern, insbesondere die erste und/oder die zweite Plasmaquelle (1, 3) ein- oder auszuschalten.

12. Vorrichtung nach einem der Ansprüche 1 bis 11, wobei die erste Entladungskammer (2) und die zweite Entladungskammer (4) zylinderförmig ausgeführt sind und hintereinander koaxial angeordnet sind, wobei das erste Ankopplungselement (5) an der ersten Entladungskammer (2) angeordnet ist und das zweite Ankopplungselement (6) an der zweiten Entladungskammer (4) angeordnet ist, wobei die erste Plasmaquelle (1) insbesondere eine Glimmentladungsquelle ist und wobei die zweite Plasmaquelle (3) insbesondere eine stille Entladungsquelle ist.

13. Vorrichtung nach Anspruch 12, wobei eine Anode (9) der ersten Plasmaquelle (1) vakuumdicht in einer Durchführung durch die optische Linse (8) im zweiten Ankopplungselement (6) eingeglast ist, und insbesondere auch in einer Durchführung durch die optische Linse (7), welche zwischen der ersten Entladungskammer (2) und der zweiten Entladungskammer (4) angeordnet ist, eingeglast ist, und die beiden Durchführungen insbesondere zentrisch in den beiden optischen Linsen (7, 8) angeordnet sind, und sich die Anode (9) koaxial durch die zweite Entladungskammer (4) hindurch bis in die erste Entladungskammer (2) erstreckt.

14. Vorrichtung nach Anspruch 12 oder 13, wobei die zweite Plasmaquelle (3) eine Hochspannungselektrode (10) und eine Masse-Elektrode (11) aufweist, wobei die Hochspannungselektrode (10) in ein Dielektrikum eingebettet ist, welches zumindest Teil einer Innenwand der zweiten Entladungskammer (4) bildet, und die Masse-Elektrode (11) konzentrisch zur Hochspannungselektrode (10) innerhalb der zweiten Entladungskammer (4) und entlang der Innenwand, in einem Abstand von weniger als 1 mm, insbesondere zwischen 0.05 mm und 0.5 mm, zur Hochspannungselektrode (10) angeordnet ist, insbesondere auf einem Hohlzylinder, z.B. aus Keramik, wobei sich zwischen der Innenwand und der Masse-Elektrode (11) ein Spalt befindet, in dem sich beim Anlegen einer Wechselspannung zwischen der Hochspannungselektrode (10) und der Masse-Elektrode (11), z.B. mit einer Spannung im Bereich von ±1 bis ±10 kV und einer Frequenz im Bereich von 1 bis 10 kHz, eine Entladungszone mit einem Plasma bildet.

15. Vorrichtung nach einem der Ansprüche 12 bis 14, wobei die Hochspannungselektrode (10) für einen Betrieb der ersten Plasmaquelle (1) mit Masse (GND) verbindbar ist und für einen Betrieb der zweiten Plasmaquelle (3) mit einer Hochspannungswechselstromquelle verbindbar ist, und/oder wobei die Anode (9) für einen Betrieb der ersten Plasmaquelle (1) mit einer Hochspannungsgleichstromquelle verbindbar ist und für einen Betrieb der zweiten Plasmaquelle (3) mit Masse (GND) verbindbar ist.

16. System zur optischen Gasanalyse bzw. Gasdetektion umfassend:
- eine Vorrichtung zur Plasmaerzeugung nach einem der Ansprüche 1 bis 15;
- eine Gasquelle, wobei die Vorrichtung zur Plasmaerzeugung mit einem ersten Ankopplungselement, insbesondere mit einem Flansch, an die Gasquelle gekoppelt ist;
- ein optischer Sensor, wie z.B. eine Fotodiode oder ein Spektrometer zur optischen Gasanalyse bzw. Gasdetektion, wobei die Vorrichtung zur Plasmaerzeugung mit einem zweiten Ankopplungselement an den optischen Sensor gekoppelt ist.

17. Verfahren zur Plasmaerzeugung in einem grossen Druckbereich mittels der Vorrichtung nach einem der Ansprüche 1 bis 15 umfassend die Schritte:
- Zuführen eines Gases aus einem System via ein erstes Ankopplungselement (5) in eine erste Entladungskammer (2) mit einer ersten Plasmaquelle (1) und/oder in eine zweite Entladungskammer (4) mit einer zweiten Plasmaquelle (3);
- Erzeugen eines ersten Plasmas (14) durch die erste Plasmaquelle (1) in einem Niederdruckbereich in der ersten Entladungskammer (2), wobei sich der Niederdruckbereich insbesondere bis Hochvakuum, d.h. beispielsweise bis 10⁻⁸ Torr, erstreckt, und/oder Erzeugen eines zweiten Plasmas (15) durch die zweite Plasmaquelle (3) in einem Hochdruckbereich in der zweiten Entladungskammer (4), wobei sich der Hochdruckbereich insbesondere bis über Normaldruck, d.h. beispielsweise bis 1500 Torr, erstreckt;
- Leiten von Licht, welches vom ersten Plasma (14) emittiert wird, von der ersten Entladungskammer (2) via eine erste optische Verbindung (L1) mit mindestens einer optischen Linse (7, 8) und/oder von Licht, welches vom zweiten Plasma (15) emittiert wird, von der zweiten Entladungskammer (4) via eine zweite optische Verbindung (L2) mit mindestens einer optischen Linse (8) zu einem zweiten Ankopplungselement (6) zur Ankopplung der Vorrichtung an einen optischen Sensor, wie z.B. eine Fotodiode oder ein Spektrometer;
- Auskoppeln zumindest eines Teils des Lichtes, welches vom ersten und/oder vom zweiten Plasma (14, 15) emittiert wird, durch das zweite Ankopplungselement (6).

18. Verfahren nach Anspruch 17, wobei in Abhängigkeit des mit Hilfe eines Drucksensors bestimmten Drucks die erste und/oder die zweite Plasmaquelle (1, 3) angesteuert wird, insbesondere die erste und/oder die zweite Plasmaquelle (1, 3) ein- oder ausgeschaltet wird.

19. Verfahren nach Anspruch 18, wobei in einem Druckbereich, in dem sich der Niederdruckbereich und der Hochdruckbereich überlappen, z.B. in einem Druckbereich von 0.35 Torr bis 3.5 Torr, die erste und zweite Plasmaquelle (1, 3) gleichzeitig ein erstes und ein zweites Plasma (14, 15) erzeugen.

20. Verfahren zur optischen Gasanalyse bzw. Gasdetektion, umfassend Ausführen der Schritte gemäss einem der Ansprüche 17 bis 19 und weiter umfassend die Schritte:
- Leiten des ausgekoppelten Lichtes an einen optischen Sensor, wie z.B. eine Fotodiode oder ein Spektrometer;
- Bestimmen eines Gases oder von Bestandteilen eines Gases oder Nachweisen eines bestimmten Gases oder bestimmter Bestandteile eines Gases oder Bestimmung eines Drucks des Gases aufgrund des ausgekoppelten Lichtes, insbesondere einer Intensität und/oder einer spektralen Verteilung des ausgekoppelten Lichtes.

## Claims

1. Device for plasma generation in a wide pressure range comprising:
- a first plasma source (1), wherein the first plasma source (1) is arranged in a first discharge chamber (2) and is adapted to generate a first plasma (14) in a low-pressure range, wherein the low-pressure range extends in particular up to high vacuum, i.e., for example up to 10⁻⁸ Torr;
- a second plasma source (3), wherein the second plasma source (3) is arranged in a second discharge chamber (4) and is adapted to generate a second plasma (15) in a high-pressure range, wherein the high-pressure range extends in particular to above normal pressure, i.e., for example to 1500 Torr;
- a first coupling element (5), in particular having a flange, for coupling the device to a system, wherein the coupling element (5) is designed to lead gas out of the system;
- a second coupling element (6) for coupling the device to an optical sensor, such as a photodiode or spectrometer, for optical gas analysis or gas detection,
wherein the first discharge chamber (2) has a first optical connection (L1) having at least one optical lens (7, 8) to the second coupling element (6), and the second discharge chamber (4) has a second optical connection (L2) having at least one optical lens (8) to the second coupling element (6).

2. Device according to claim 1, wherein the low-pressure range and the high-pressure range together extend over a pressure range of at least 10 decades, in particular over 12 decades.

3. Device according to claim 1 or 2, wherein the low-pressure range and the high-pressure range overlap, in particular over a pressure range of one decade, e.g., from 0.35 Torr to 3.5 Torr.

4. Device according to one of claims 1 to 3, wherein the first and second plasma sources (1, 3) are different plasma sources, e.g., one each from the group consisting of a glow discharge source, a silent discharge source, a radio frequency plasma source, a microwave plasma source, and an inductively coupled plasma source.

5. Device according to one of claims 1 to 4, wherein the first discharge chamber (2) is fluidically coupled to the second discharge chamber (4).

6. Device according to one of claims 1 to 5, wherein gas can be supplied from the first coupling element (5) into the first discharge chamber (2) and can be supplied from the first discharge chamber (2) into the second discharge chamber (4).

7. Device according to one of claims 1 to 6, wherein an optical lens (7), which is part of the first optical connection (L1), is arranged between the first discharge chamber (2) and the second discharge chamber (4).

8. Device according to one of claims 1 to 7, wherein the second coupling element (6) comprises an optical lens (8) which is part of the first and/or the second optical connection (L1, L2).

9. Device according to one of claims 1 to 8, wherein the second optical connection (L2) is part of the first optical connection (L1).

10. Device according to one of claims 1 to 9, wherein the device further comprises a pressure sensor.

11. Device according to claim 10, wherein the device further comprises a controller which is designed to control the first and/or the second plasma source (1, 3), in particular to switch the first and/or the second plasma source (1, 3) on or off, as a function of the pressure determined by means of the pressure sensor.

12. Device according to one of claims 1 to 11, wherein the first discharge chamber (2) and the second discharge chamber (4) are of cylindrical design and are arranged coaxially one behind the other, wherein the first coupling element (5) is arranged on the first discharge chamber (2) and the second coupling element (6) is arranged on the second discharge chamber (4), wherein the first plasma source (1) is in particular a glow discharge source and wherein the second plasma source (3) is in particular a silent discharge source.

13. Device according to claim 12, wherein an anode (9) of the first plasma source (1) is glazed in a vacuum-tight manner in a feedthrough through the optical lens (8) in the second coupling element (6), and in particular also in a feedthrough through the optical lens (7), which is arranged between the first discharge chamber (2) and the second discharge chamber (4), and the two feedthroughs are arranged in particular centrally in the two optical lenses (7, 8), and the anode (9) extends coaxially through the second discharge chamber (4) into the first discharge chamber (2).

14. Device according to claim 12 or 13, wherein the second plasma source (3) has a high-voltage electrode (10) and a ground electrode (11), wherein the high-voltage electrode (10) is embedded in a dielectric which forms at least part of an inner wall of the second discharge chamber (4), and the ground electrode (11) is arranged concentrically to the high-voltage electrode (10) within the second discharge chamber (4) and along the inner wall, at a distance of less than 1 mm, in particular between 0.05 mm and 0.5 mm, from the high-voltage electrode (10), in particular on a hollow cylinder, e.g., of ceramic, wherein a gap is located between the inner wall and the ground electrode (11), in which gap a discharge zone with a plasma is formed when an alternating voltage is applied between the high-voltage electrode (10) and the ground electrode (11), e.g., with a voltage in the range from ±1 to ±10 kV and a frequency in the range from 1 to 10 kHz.

15. Device according to one of claims 12 to 14, wherein the high-voltage electrode (10) is connectable to ground (GND) for operation of the first plasma source (1) and is connectable to a high-voltage alternating current source for operation of the second plasma source (3), and/or wherein the anode (9) is connectable to a high-voltage direct current source for operation of the first plasma source (1) and is connectable to ground (GND) for operation of the second plasma source (3).

16. System for optical gas analysis or gas detection comprising:
- a device for plasma generation according to one of claims 1 to 15;
- a gas source, wherein the device for plasma generation is coupled to the gas source with a first coupling element, in particular with a flange;
- an optical sensor, such as a photodiode or a spectrometer for optical gas analysis or gas detection, wherein the plasma generation device is coupled to the optical sensor by a second coupling element.

17. Method for plasma generation in a wide pressure range by means of the device according to one of claims 1 to 15, comprising the steps of:
- feeding a gas from a system via a first coupling element (5) into a first discharge chamber (2) having a first plasma source (1) and/or into a second discharge chamber (4) having a second plasma source (3);
- generating a first plasma (14) by the first plasma source (1) in a low-pressure range in the first discharge chamber (2), wherein the low-pressure range extends in particular to high vacuum, i.e., for example to 10⁻⁸ Torr, and/or generating a second plasma (15) by the second plasma source (3) in a high-pressure range in the second discharge chamber (4), wherein the high-pressure range extends to above normal pressure, i.e., for example, to 1500 Torr;
- guiding light which is emitted from the first plasma (14) from the first discharge chamber (2) via a first optical connection (L1) having at least one optical lens (7, 8) and/or light emitted from the second plasma (15) from the second discharge chamber (4) via a second optical connection (L2) having at least one optical lens (8) to a second coupling element (6) for coupling the device to an optical sensor, such as a photodiode or a spectrometer;
- coupling out at least a portion of the light, which is emitted by the first and/or the second plasma (14, 15), by the second coupling element (6).

18. Method according to claim 17, wherein the first and/or the second plasma source (1, 3) is controlled as a function of the pressure determined with the aid of a pressure sensor, in particular the first and/or the second plasma source (1, 3) is switched on or off.

19. Method according to claim 18, wherein in a pressure range in which the low-pressure range and the high-pressure range overlap, e.g., in a pressure range of 0.35 Torr to 3.5 Torr, the first and second plasma sources (1, 3) simultaneously generate a first and a second plasma (14, 15).

20. Method for optical gas analysis or gas detection, comprising carrying out the steps according to one of claims 17 to 19 and further comprising the steps of:
- directing the decoupled light to an optical sensor, such as a photodiode or spectrometer;
- determining a gas or components of a gas or detecting a specific gas or specific components of a gas or determining a pressure of the gas based on the decoupled light, in particular an intensity and/or a spectral distribution of the decoupled light.

## Revendications

1. Dispositif de génération de plasma dans une large gamme de pressions, comprenant :
- une première source de plasma (1), la première source de plasma (1) étant agencée dans une première chambre de décharge (2) et exécutée de façon à générer un premier plasma (14) dans une gamme de basses pressions, la gamme de basses pressions s'étendant en particulier jusqu'au vide poussé, à savoir par exemple jusqu'à 10⁻⁸ Torr ;
- une seconde source de plasma (3), la seconde source de plasma (3) étant agencée dans une seconde chambre de décharge (4) et exécutée de façon à générer un second plasma (15) dans une gamme de hautes pressions, la gamme de hautes pressions s'étendant en particulier jusqu'à une pression supérieure à la pression normale, à savoir par exemple jusqu'à 1500 Torr ;
- un premier élément d'accouplement (5), en particulier présentant une première bride, destiné à coupler le dispositif avec un système, l'élément d'accouplement (5) étant exécuté pour expulser du gaz hors du système ;
- un second élément d'accouplement (6) destiné à coupler le dispositif à un détecteur optique, tel que par exemple une photodiode ou un spectrophotomètre, pour réaliser une analyse optique de gaz ou une détection optique de gaz,
dans lequel la première chambre de décharge (2) présente une première liaison optique (L1) avec au moins un objectif optique (7, 8) vers le second élément d'accouplement (6), et la seconde chambre de décharge (4) présente une seconde liaison optique (L2) avec au moins un objectif optique (8) vers le second élément d'accouplement (6).

2. Dispositif selon la revendication 1, dans lequel la gamme des basses pressions et la gamme des hautes pressions s'étendent ensemble sur une gamme de pressions d'au moins 10 décades, en particulier de plus de 12 décades.

3. Dispositif selon la revendication 1 ou 2, dans lequel la gamme des basses pressions et la gamme des hautes pressions se chevauchent, en particulier sur une gamme de pressions d'une décade, par exemple de 0,35 à 3,5 Torr.

4. Dispositif selon l'une des revendications 1 à 3, dans lequel la première et la seconde sources de plasma (1, 3) sont des sources de plasma différentes, par exemple chacune issue du groupe composé d'une source à décharge luminescente, d'une source à décharge silencieuse, d'une source de plasma haute fréquence, d'une source de plasma à micro-ondes et d'une source de plasma à couplage inductif.

5. Dispositif selon l'une des revendications 1 à 4, dans lequel la première chambre de décharge (2) est couplée par voie fluidique avec la seconde chambre de décharge (4).

6. Dispositif selon l'une des revendications 1 à 5, dans lequel du gaz peut être amené depuis le premier élément d'accouplement (5) dans la première chambre de décharge (2) et peut être amené depuis la première chambre de décharge (2) dans la seconde chambre de décharge (4).

7. Dispositif selon l'une des revendications 1 à 6, dans lequel est disposé entre la première chambre de décharge (2) et la seconde chambre de décharge (4) un objectif optique (7) qui est une partie de la première liaison optique (L1).

8. Dispositif selon l'une des revendications 1 à 7, dans lequel le second élément d'accouplement (6) comprend un objectif optique (8) qui est une partie de la première et/ou de la seconde liaison optique (L1, L2).

9. Dispositif selon l'une des revendications 1 à 8, dans lequel la seconde liaison optique (L2) est une partie de la première liaison optique (L1).

10. Dispositif selon l'une des revendications 1 à 9, dans lequel le dispositif comporte en outre un capteur de pression.

11. Dispositif selon la revendication 10, dans lequel le dispositif comporte en outre une commande qui est exécutée pour commander, en fonction de la pression déterminée, à l'aide du détecteur de pression, la première et/ou la seconde source de plasma (1, 3), en particulier pour activer ou désactiver la première et/ou la seconde sources de plasma (1, 3).

12. Dispositif selon l'une des revendications 1 à 11, dans lequel la première chambre de décharge (2) et la seconde chambre de décharge (4) sont exécutées en forme de cylindre et sont disposées de façon coaxiale l'une derrière l'autre, le premier élément d'accouplement (5) étant agencé au niveau de la première chambre de décharge (2) et le second élément d'accouplement (6) étant agencé au niveau de la seconde chambre de décharge (4), la première source de plasma (1) étant en particulier une source à décharge luminescente et la seconde source de plasma (3) étant en particulier une source à décharge silencieuse.

13. Dispositif selon la revendication 12, dans lequel une anode (9) de la première source de plasma (1) est vitrifiée de façon étanche au vide dans une traversée via l'objectif optique (8) dans le second élément d'accouplement (6), et en particulier aussi vitrifiée, dans une traversée via l'objectif optique (7) qui est agencé entre la première chambre de décharge (2) et la seconde chambre de décharge (4), et les deux traversées sont agencées en particulier de façon centrale dans les deux objectifs optiques (7, 8), et l'anode (9) s'étend de façon coaxiale par la seconde chambre de décharge (4) jusqu'à la première chambre de décharge (2).

14. Dispositif selon la revendication 12 ou 13, dans lequel la seconde source de plasma (3) présente une électrode haute tension (10) et une électrode de masse (11), l'électrode haute tension (10) étant incorporée dans un diélectrique qui forme au moins une partie d'une paroi interne de la seconde chambre de décharge (4), et l'électrode de masse (11) étant agencée de façon concentrique par rapport à l'électrode haute tension (10) au sein de la seconde chambre de décharge (4) et le long de la paroi interne, selon un écart de moins de 1 mm, en particulier entre 0,05 mm et 0,5 mm, par rapport à l'électrode haute tension (10), en particulier sur un cylindre creux, par exemple en céramique, une fente se trouvant entre la paroi interne et l'électrode de masse (11), dans laquelle, lors de l'application d'une tension alternative entre l'électrode haute tension (10) et l'électrode de masse (11), par exemple avec une tension dans la plage de ± 1 à ± 10 kV et une fréquence dans la plage de 1 à 10 kHz, se forme une zone de décharge avec un plasma.

15. Dispositif selon l'une des revendications 12 à 14, dans lequel l'électrode haute tension (10) peut être reliée, pour une exploitation de la première source de plasma (1), avec la masse (GND), et peut être reliée, pour une exploitation de la seconde source de plasma (3), avec une source de courant alternatif haute tension, et/ou dans lequel l'anode (9) peut être reliée, pour une exploitation de la première source de plasma (1), avec une source de courant continu haute tension, et peut être reliée, pour une exploitation de la seconde source de plasma (3), avec la masse (GND).

16. Système d'analyse optique de gaz ou de détection optique de gaz, comprenant :
- un dispositif de génération de plasma selon l'une des revendications 1 à 15 ;
- une source de gaz, le dispositif de génération de plasma étant couplé à la source de gaz, avec un premier élément d'accouplement, en particulier avec une bride ;
- un détecteur optique, par exemple une photodiode ou un spectrophotomètre, permettant l'analyse optique de gaz ou la détection optique de gaz, le dispositif de génération de plasma étant couplé au détecteur optique avec un second élément d'accouplement.

17. Procédé de génération de plasma dans une large gamme de pressions au moyen du dispositif selon l'une des revendications 1 à 15, comprenant les étapes suivantes consistant à :
- amener un gaz depuis un système, via un premier élément d'accouplement (5), dans une première chambre de décharge (2) équipée d'une première source de plasma (1) et/ou dans une seconde chambre de décharge (4) équipée d'une seconde source de plasma (3) ;
- générer un premier plasma (14) via la première source de plasma (1) dans une plage de basses pressions dans la première chambre de décharge (2), la gamme de basses pressions s'étendant en particulier jusqu'au vide poussé, à savoir par exemple jusqu'à 10⁻⁸ torr, et/ou générer un second plasma (15) via la seconde source de plasma (3) dans une gamme de hautes pressions dans la seconde chambre de décharge (4), la gamme de hautes pressions s'étendant en particulier jusqu'à une pression supérieure à la normale, à savoir par exemple jusqu'à 1500 torr ;
- diriger de la lumière qui est émise par le premier plasma (14) depuis la première chambre de décharge (2), via une première liaison optique (L1), avec au moins un objectif optique (7, 8), et/ou de la lumière qui est émise par le second plasma (15) depuis la seconde chambre de décharge (4), via une seconde liaison optique (L2), avec au moins un objectif optique (8), vers un second élément d'accouplement (6) afin de coupler le dispositif à un détecteur optique, comme par exemple une photodiode ou un spectrophotomètre ;
- découpler au moins une partie de la lumière qui est émise par le premier et/ou le second plasma (14, 15) via le second élément d'accouplement (6).

18. Procédé selon la revendication 17, dans lequel, en fonction de la pression déterminée à l'aide d'un capteur de pression, on commande la première et/ou la seconde sources de plasma (1, 3), et en particulier on active ou désactive la première et/ou la seconde sources de plasma (1, 3).

19. Procédé selon la revendication 18, dans lequel, dans une gamme de pressions dans laquelle la gamme de basses pressions et la gamme des hautes pressions se chevauchent, par exemple dans une gamme de pressions de 0,35 torr à 3,5 torr, la première et la seconde sources de plasma (1, 3) génèrent simultanément un premier et un second plasmas (14, 15).

20. Procédé d'analyse optique de gaz ou de détection optique de gaz comprenant la réalisation des étapes selon l'une des revendications 17 à 19 et comprenant en outre les étapes consistant à :
- diriger la lumière découplée au niveau d'un détecteur optique, par exemple une photodiode ou un spectrophotomètre ;
- déterminer un gaz ou des composés d'un gaz, ou détecter un gaz déterminé ou des composés déterminés d'un gaz, ou déterminer une pression du gaz sur la base de la lumière découplée, en particulier une intensité et/ou une répartition spectrale de la lumière découplée.
